# EUROPÄISCHE PATENTANMELDUNG

(11) **EP 0 684 757 A1**
(43) Veröffentlichungstag der Anmeldung: **29.11.1995**
(21) Anmeldenummer: 95107953.2
(22) Anmeldetag: 24.05.1995
(51) Int. Cl.: H05K 13/00, H05K 13/02, B65G 47/14, B65G 51/03

(54) **Verfahren und Einrichtung zur Zuführung von elektronischen Bauteilen zu einem Bestückungsautomaten**

(30) Priorität: 27.05.1994 DE 4418467
(71) Anmelder: SIEMENS AKTIENGESELLSCHAFT, D-80333 München (DE)
(72) Erfinder: Ahrens, Hans-Joachim, D-22175 Hamburg (DE); Roggon, Roland, Dipl.-Ing., D-21521 Wohltorf (DE)

(57) **Zusammenfassung**

Einrichtung (feeder) zur Zuführung von elektronischen Bauteilen zu einem Bestückungsautomaten, z.B. SMD-Automaten, mit einer Transportschiene und einer vorgeschalteten pneumatischen Wirbelkammer, wobei die Transportschiene als klappen-und ventilloser pneumatischer Förderer ausgebildet ist sowie Verfahren zum Betreiben der Einrichtung.

## Beschreibung

Die Erfindung betrifft ein Verfahren und eine Einrichtung zur Zuführung von in einem bulk case befindlichen Bauelementen zu einem Bestückungsautomaten, z.B. zu einem SMD-Automaten, mittels einer Transportschiene und einer der Transportschiene vorgeschalteten Wirbelkammer zur Auflokkerung und Ausrichtung der Bauelemente.

Bei der Zuführung von in einem bulk case befindlichen Bauelementen zu einem Bestückungsautomaten gibt es bei der Verwendung elektromechanischer Verfahren immer wieder Probleme. Das am häufigsten auftretende Problem ergibt sich durch ungleichmäßige Abstände zwischen den einzelnen Bauelementen am Übergang der Vereinzelung zu der Förderstrecke. Hier kommt es aufgrund der ungleichmäßigen Abstände der Bauelemente zueinander immer wieder zu einer Fehlfunktion der mechanischen Komponenten. Dies führt zu Betriebsstörungen.

Es ist Aufgabe der Erfindung, ein Verfahren für die Zuführung von in einem bulk case befindlichen Bauelementen zu einem Bestückungsautomaten anzugeben, daß einen problemlosen Betrieb ermöglicht.

Die Aufgabe wird dadurch gelöst, daß die Bewegung der Bauelemente, soweit sie nicht schwerkraftbedingt ist, pneumatisch erfolgt. Durch die pneumatische Bewegung der Bauelemente kann vorteilhaft auf die störungsanfälligen elektromechanischen Komponenten einer Zuführung verzichtet werden. Die Betriebssicherheit wird hierdurch erheblich erhöht.

In Ausgestaltung der Erfindung ist vorgesehen, daß die Bewegung der Bauelemente durch einen pulsierenden Luftstrom erfolgt. Ein pulsierender Luftstrom hat sich als besonders geeignet herausgestellt, sowohl die Bauelemente in der Wirbelkammer aufzulockern, als auch eng aneinander anliegend in Richtung auf die Transportschiene vorzuschieben.

In Ausgestaltung des Verfahrens ist weiterhin vorgesehen, daß die Pulsluft abschnittsweise verteilt zugeführt wird, wobei eine ventillose Zuführung erfolgt. So ergibt sich sowohl ein störungsfreier Betrieb als auch eine hohe Fördergeschwindigkeit.

In weiterer Ausgestaltung des Verfahrens ist vorgesehen, daß die Pulsation der Luft in einem pneumatischen Schwingkreis erzeugt wird, wobei dieser durch ein schwingendes mechanisches System, insbesondere durch ein Feder-Massensystem angeregt wird und wobei die Anregung durch eine Überlagerung des Speiseluftstroms für die pneumatische Bewegung mit dem pneumatischen Schwingkreis erfolgt. So ergibt sich ein sehr vorteilhaftes, anpassungsfähiges und eine im Bereich des feeders ventillos arbeitende Verfahrensweise, die den bekannten elektromechanischen Verfahren in bezug auf die Betriebssicherheit weit überlegen ist.

Elektronische Bauteile für SMD-Automaten, die nicht auf Glisterbändern o.ä. zugeführt werden, werden bekannterweise auch durch mechanische Förderer, z.B. Rüttelförderer oder auch pneumatisch/mechanische Förderer zugeführt. Sowohl die mechanischen als auch die pneumatisch/mechanischen Förderer sind störanfällig, wobei es gleichgültig ist, ob es sich um Schwingförderer, Riemenförderer oder pneumatische Rohrförderer mit elektromechanischen Vereinzelungselementen handelt.

Es ist eine weitere Aufgabe der Erfindung, eine Einrichtung zur Zuführung von elektronischen Bauteilen zu einem SMD-Automaten aus einem bulk case anzugeben, der die vorstehenden Nachteile nicht aufweist und sich durch eine besonders hohe Zuverlässigkeit sowie leichte Anpaßbarkeit an unterschiedliche, und zwar sowohl runde als auch eckige, elektronische Bauteile auszeichnet.

Die Aufgabe wird dadurch gelöst, daß die Transportschiene, die den Hauptteil des Förderers bildet, als klappen- und ventilloser pneumatischer Förderer ausgebildet ist. Durch die klappen- und ventillose Ausbildung der Transportschiene ergibt sich eine besonders störungsfreie Arbeitsweise. Die Transportschiene ist einfach aufgebaut, damit kostengünstig sowie gut handhabbar und wartbar. Durch den einfachen Aufbau ergibt sich auch eine besonders einfache Umrüstbarkeit und Anpaßbarkeit an unterschiedliche räumliche Verhältnisse. So kann z.B. die Länge durch die Ausbildung von pneumatischen Einzeltransportabschnitten mit separater Luftzu- und -abfuhr leicht geändert werden.

In Ausgestaltung der Erfindung ist dabei vorgesehen, daß der pneumatische Förderer Luftzuführungselemente aufweist, die insbesondere als Luftzuführungsröhrchen ausgebildet sind und daß im Anschluß an die Luftzuführungselemente Luftableitungselemente, z.B. in Form von Auslaßöffnungen angeordnet sind. So ergibt sich die gewünschte Variabilität in der Länge des pneumatischen Förderers ohne die Einfachheit des Grundkonzepts zu verlassen. Die Zuführung des pneumatischen Fördermittels, vorzugsweise trockene Luft, mit einem Druck von 5 bar, geschieht durch gegenüber der Förderrichtung schräg angeordnete Luftzuführungsdüsen, in einfachster Form als Luftzuführungsröhrchen ausgebildet. Je nach Form und Gewicht der elektronischen Bauteile werden diese Luftzuführungsröhrchen unterschiedlich geneigt, etwa im Winkel von 3 bis 30 °.

Vor dem pneumatischen Förderer ist vorteilhaft eine Wirbelkammer mit einer pneumatischen Ventilsteuerung angeordnet, über die Impulse in der Wirbelkammer erzeugbar und ggf. auf eine federnde Überführung zwischen der Wirbelkammer und dem pneumatischen Förderer übertragbar sind. Durch die Wirbelkammer ist vorteilhaft eine Aufreihung der in loser Schüttung vorliegenden elektronischen Bauteile, überraschend in Kleingruppen, möglich. Diese Kleingruppen, die sich durch Setzbewegungen auf einer unter der Wirbelkammer angeordneten Führungsschiene ergeben, lassen sich besonders vorteilhaft weiterfördern, wobei sich beim Durchlaufen des pneumatischen Förderers sehr vorteilhaft selbsttätig ein gleichmäßiger Abstand zwischen den einzelnen elektronischen Bauteilen ergibt. Die vereinzelten Bauteile treten in einem zeitlichen Abstand von unter 150 ms aus dem pneumatischen Förderer aus, so daß sich eine gute Anpassung an die sehr hohen Taktraten moderner SMD-Automaten ergibt.

Die Erfindung wird anhand von Zeichnungen näher erläutert, aus denen sich, ebenso wie aus den Unteransprüchen und der Zeichnungsbeschreibung noch weitere, auch erfinderische, Einzelheiten ergeben. Im einzelnen zeigen:
FIG 1 einen pneumatischen Förderer mit Wirbelkammereinheit und federnder Überführung sowie
FIG 2 einen Querschnitt durch den pneumatischen Förderer,
FIG 3 Einzelheiten der Pulsluftzuführung im Vereinzelungsbereich,
FIG 4 das Prinzip der Schwingkreisanregung und
FIG 5 die Pulsluftführung in der Transportschiene.

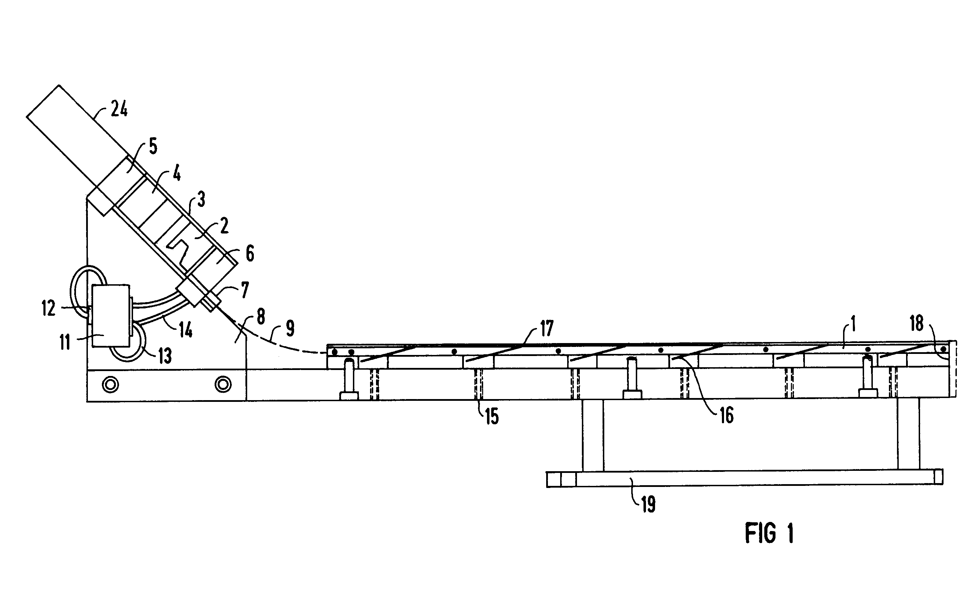

In FIG 1 bezeichnet 1 den pneumatischen Förderer und 2 die Wirbelkammer mit dem Deckel 3. Vor der Wirbelkammer ist hinter einem oberen Block 5 eine Glasplatte 4 angeordnet, durch die die Füllung mit elektronischen Bauteilen, z.B. elektronischen Standard-Bauelementen wie Widerständen, Kondensatoren, Transistoren etc. beobachtet werden kann. An die Wirbelkammer 2 schließt sich in Förderrichtung ein unterer Block 6 an, aus dem eine Düse 7 die elektronischen Bauteile auf das federnde Übergabeelement 9 überleitet. Der untere Block 6 wird mit Verteilung der zugeführten Luft in die Wirbelkammer 2 und die Düse 7 durch Zuleitungen 14 von einem pneumatischen Ventil, im Block 11 mit Förderluft versorgt. Das pneumatische Ventil in dem Block 11 ist mit Luftrückführungen 13 vesehen, so daß über Drosseln eine Selbstschaltung des Ventils erreichbar ist. Auch hier ist also kein elektrischer Anschluß notwendig, die gesamte Einrichtung arbeitet also rein pneumatisch. Die Drosseln sind einstellbar, so daß sich eine einstellbare Vereinzelungs- und Förderrate ergibt. Die Teile 2 bis 7 sowie 10 bis 14 werden von dem Leiterelement 8, z.B. einem Blech, gehalten.

Im Anschluß an das Durchlaufen der Federzuführung 9 treten die elektronischen Bauteile in die pneumatische Förderrinne 1 ein, in der einzelne Luftzuführungselemente, z.B. die Röhrchen 16 angeordnet sind. Die zugeführte Luft tritt durch Öffnungen 15 ein und verläßt durch besondere Austrittsbereiche, z.B. längliche Öffnungen. Am Ende der pneumatischen Förderrinne 1 befindet sich noch ein Anschlag 18. Die pneumatische Förderrinne 1 ist auf einem Gestell 19 angeordnet, das einfach durch Verschraubungen an der passenden Stelle vor dem SMD-Automaten angebracht werden kann. Vorteilhaft wird für den pneumatischen Förderer selbst eine Stift-Bohrung-Fixierung mit Dauermagnethalterung verwendet. So ist ein Andocken sowohl des bulk case mit rüttelsicherem Reibungsschluß unter guter Zugänglichkeit gewährleistet wie auch ein Andocken des pneumatischen Förderers an den SMD-Automaten.

Vorteilhaft wird für ein Auffüllen des Bauteilvorrats, das jederzeit möglich ist, ein Sensor für ein Vorsignal vorgesehen. Um eine ständige Bewegung der Bauteile zu vermeiden, ist für einen Maschinenstillstand ein Absperr-Hauptventil für die Luftversorgung vorgesehen. Ein Entleeren des feeders ist einfach durch Kippen möglich. Eine Reinigung, z.B. durch Absaugen. Von besonderem Vorteil ist dabei das Nichtvorhandensein von beweglichen Teilen.

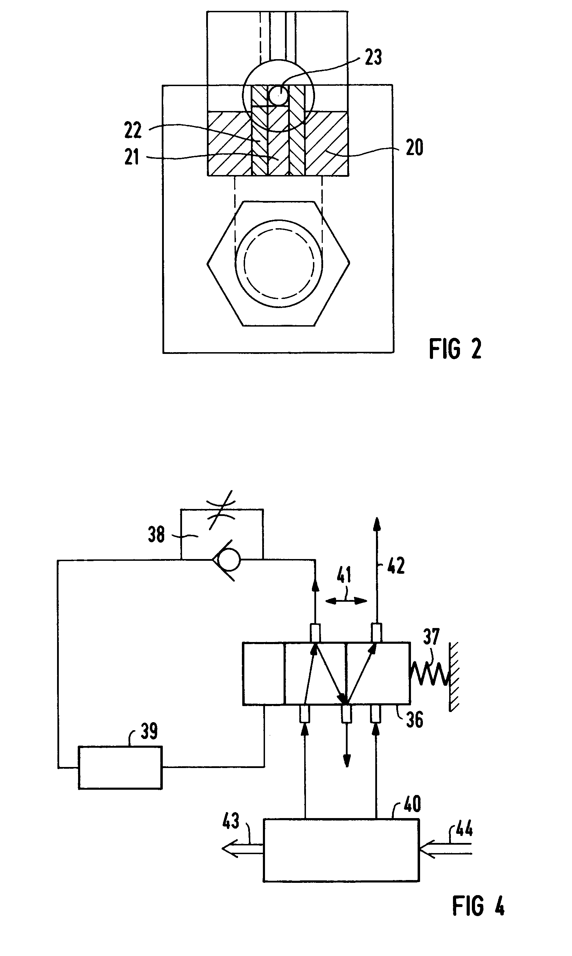

In FIG 2, die einen Schnitt durch den pneumatischen Förderer zeigt, bezeichnet 20 eine seitliche Distanzleiste und 21 die mittlere Distanzleiste. Im Bereich 22 findet die Luftzuführung statt, während 23 ein gefördertes Bauteil bezeichnet. Wie für den Fachmann ersichtlich, ist eine einfache Einstellung des pneumatischen Förderers auf Bauteile unterschiedlicher Abmessungen und Formen möglich.

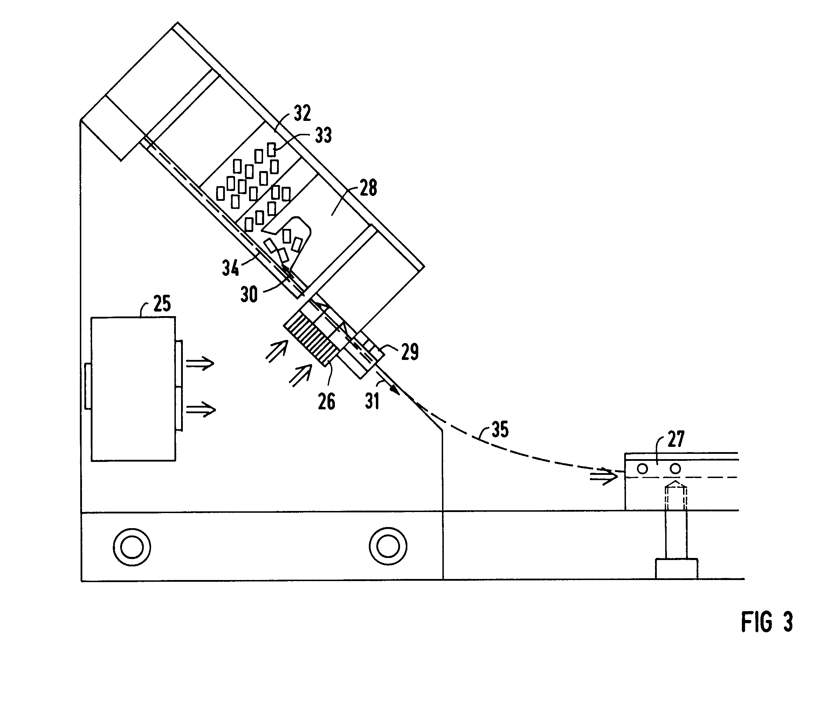

In FIG 3 bezeichnet 25 von dem durch die eingezeichneten Pfeile angedeutete Verbindungsleitungen zu dem Lufteintrittsblock 26 und der Transportschiene 27 verlaufen. Aus dem Lufteintrittsblock 26 tritt die Pulsluft sowohl in die Wirbelkammer 28 als auch in die Düse 29 aus. Der Austritt der Pulsluft ist durch Pfeile 30 und 31 angedeutet. Die in der Wirbelkammer 28 und der Vorkammer 32 befindlichen Bauelemente 33 werden durch die Pulsluft aufgelockert und legen sich unter Ausnutzung der Schwerkraftwirkung in die Führungsnut 34 aufgereiht ein. Durch die Pulsluft aufgelockert, gelangen sie aus der Führungsnut in die Federzuführung 35 und von dort in die Transportschiene 27, wo sie von der stirnseitig in die Transportschiene 27 eingeleitete Pulsluft weitergefördert werden.

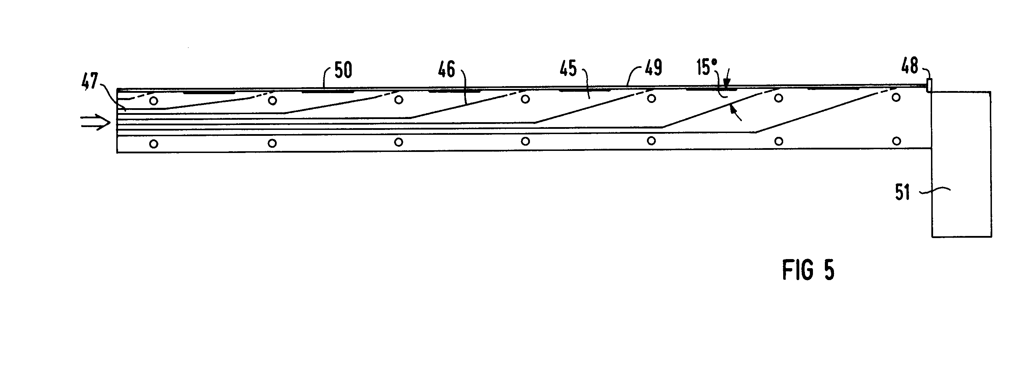

In FIG 4 bezeichnet 36 einen Ventilschieber, der seitlich eine Feder 37 aufweist. Nach Anregung führt der Ventilschieber 36 eine oszillierende Bewegung aus, die durch den Doppelpfeil 41 angedeutet ist und die sich durch die einstellbare Drossel 38 und den Pufferspeicher 39 einstellen laßt. Die einzelnen Luftwege sind durch Pfeile in üblicher Art angedeutet. Der Ventilblock 36 wird durch den Verteiler 40, in den der Hauptluftanschluß 44 einmündet mit Luft versorgt. 42 deutet den Austritt der Pulsluft in die Wirbelkammer an. Die Luft für die Transportschiene wird in dem gezeigten Beispiel direkt, d.h. nicht pulsierend, aus dem Verteiler 40 entnommen, wie es der Pfeil 43 andeutet. Wie in der vorstehenden Beschreibung ausgeführt, kann jedoch auch mit pulsierender Luft gearbeitet werden, die ebenso wie die Luft für die Wirbelkammer erzeugt wird.

In FIG 5 bezeichnet 45 die Transportschiene mit Luftzuführungskanälen 46. In ihrem Oberteil befinden sich eine oder mehrere Gleitrippen oder Distanzleisten. Die Transportschiene 45 ist zumindest in diesem Teil, aus fertigungstechnischen Gründen aber vorteilhafterweise vollständig, mit einer Spezial-Hartchromschicht überzogen. Nach oben wird die Transportschiene 45 mit einer Dekkelleiste 49, insbesondere aus antistatischem, durchsichtigem Kunststoff abgedeckt, die abschnittsweise Luftaustrittsschlitze 50 freiläßt, die vor dem verchromen eingebracht werden. Durch diese Luftaustrittsschlitze 50 können ebenso wie die im ersten Teil der Figurenbeschreibung erwähnten Luftaustrittsöffnungen Teile der Förderluft austreten. Stirnseitig befindet sich an der Stirnfläche 47 ein nicht näher gezeigter Luftverteilungskopf, dem die Förderluft zugeführt wird und der diese auf die einzelnen Luftkanäle 46 verteilt. Die Luftkanäle 46 werden vorteilhaft in ihrem oberen Teil durch Funkenerosion eingebracht. An der der Luftzuführungsseite gegenüberliegenden Seite, an der die Bauelemente für den SMD-Automaten abgenommen werden, befindet sich ein Anschlagblock 51, an dessen stirnseitigem oberen Ende ein Stopper 48 für die Bauelemente angeordnet ist. Der Stopper 48 ist derart bemessen, daß hier die Förderluft stirnseitig austreten kann.

## Patentansprüche

1. Verfahren zur Zuführung von in einem bulk case befindlichen Bauelementen zu einem Bestückungsautomaten, z.B. zu einem SMD-Automaten, mittels einer Transportschiene und einer der Transportschiene vorgeschalteten Wirbelkammer zur Auflockerung und Ausrichtung der Bauelemente, dadurch gekennzeichnet, daß die Bewegung der Bauelemente, soweit sie nicht schwerkraftbedingt ist, pneumatisch erfolgt.

2. Verfahren nach Anspruch 1,
dadurch gekennzeichnet,
daß die Bewegung der Bauelemente durch einen pulsierenden Luftstrom erfolgt.

3. Verfahren nach Anspruch 2,
dadurch gekennzeichnet,
daß die Pulsluft abschnittsweise verteilt zugeführt wird.

4. Verfahren nach Anspruch 2 oder 3,
dadurch gekennzeichnet,
daß die Zuführung der Pulsluft ventillos erfolgt.

5. Verfahren nach Anspruch 2,3 oder 4,
dadurch gekennzeichnet,
daß die Pulsation der Luft mit einem pneumatischen Schwingkreis erzeugt wird.

6. Verfahren nach Anspruch 5,
dadurch gekennzeichnet,
daß der pneumatische Schwingkreis durch ein schwingendes mechanisches System, insbesondere durch ein Feder-Massen-System, angeregt wird.

7. Verfahren nach Anspruch 1,2,3,4,5 oder 6, dadurch gekennzeichnet,
daß die Anregung durch eine Überlagerung des Speiseluftstromes für die pneumatische Regelung mit dem pneumatischen Schwingkreis erfolgt.

8. Einrichtung (feeder) zur Zuführung von elektronischen Bauteilen zu einem Bestückungsautomaten, z.B. SMD-Automaten, mit einer Transportschiene und einer vorgeschalteten pneumatischen Wirbelkammer, insbesondere nach einem oder mehreren der vorhergehenden Ansprüche,
dadurch gekennzeichnet,
daß die Transportschiene als klappen- und ventilloser pneumatischer Förderer (1) ausgebildet ist.

9. Einrichtung nach Anspruch 8,
dadurch gekennzeichnet,
daß zwischen der pneumatischen Wirbelkammer (2) und dem pneumatischen Förderer (1) eine federnde Überführung (9) angeordnet ist.

10. Einrichtung nach Anspruch 8 oder 9,
dadurch gekennzeichnet,
daß der pneumatische Förderer (1) an die Maße und Formen unterschiedlicher Bauelemente anpaßbar ausgebildet ist, z.B. durch einlegbare Distanzleisten (20,21).

11. Einrichtung nach Anspruch 8,9 oder 10, dadurch gekennzeichnet,
daß der pneumatische Förderer (1) verteilte Luftzuführungselemente aufweist, die insbesondere als Luftzuführungsschlitze (16) ausgebildet sind.

12. Einrichtung nach Anspruch 11,
dadurch gekennzeichnet,
daß die Luftzuführungselemente unter einem Winkel gegenüber der Verlaufsrichtung des pneumatischen Förderers angeordnet sind, insbesondere unter einem Winkel von 3 bis 30_{°}.

13. Einrichtung nach Anspruch 11 oder 12,
dadurch gekennzeichnet,
daß im Anschluß an die Luftzuführungselemente Luftableitungselemente, z.B. in Form von Luftauslaßöffnungen (17) oder Spalten gegenüber der oberen Abdeckfung der Transportschiene angeordnet sind, insbesondere vor dem nächsten Luftzuführungselement.

14. Einrichtung nach Anspruch 8,9,10,11,12 oder 13,
dadurch gekennzeichnet,
daß für die zugeführte Luft eine pneumatische Ventilsteuerung vorgesehen ist, über die Luftimpulse in der Wirbelkammer (2) und dem pneumatischen Förderer (1) erzeugbar und gegebenenfalls auf die federnde Überführung (9) übertragbar sind.

15. Einrichtung nach Anspruch 8,9,10,11,12,13 oder 14,
dadurch gekennzeichnet,
daß unterhalb der Wirbelkammer (2) eine Führungsschiene (10) angeordnet ist, auf der sich die elektronischen Bauelemente in Gruppen aufreihen.

16. Einrichtung nach einem oder mehreren der vorhergehenden Ansprüche, dadurch gekennzeichnet,
daß der Arbeitsdruck der pneumatischen Komponenten zwischen 3 und 6 bar, insbes. 5 bar, beträgt.

17. Einrichtung nach einem oder mehreren der vorhergehenden Ansprüche, dadurch gekennzeichnet,
daß alle Einzelteile, wie der pneumatische Förderer, die Wirbelkammer und die pneumatische Ventilsteuerung keine elektrische Komponenten aufweisen.
